# EUROPEAN PATENT APPLICATION

(11) **EP 2 581 945 A2**
(43) Date of publication of application: **17.04.2013**
(21) Application number: 12174855.2
(22) Date of filing: 03.07.2012
(51) Int. Cl.: H01L 31/042

(54) **Photovoltaic package**

(30) Priority: 14.10.2011 TW 100137399
(71) Applicant: AU Optronics Corporation, Hsin-Chu (TW)
(72) Inventor: Kung, Kuo-Sen, Hsin-Chu (TW); Tu, Chun-Hao, Hsin-Chu (TW); Jhan, Ren-Hong, Hsin-Chu (TW); Wu, Wei-Cheng, Hsin-Chu (TW); Tseng, Jen-Pei, Hsin-Chu (TW); Liu, Yu-Jung, Hsin-Chu (TW); Chang, Jiun-Jye, Hsin-Chu (TW)
(74) Representative: Lang, Christian

(57) **Abstract**

A photovoltaic package includes a substrate, a photovoltaic cell, an electric device, a cover, and an encapsulating material. The photovoltaic cell is disposed on the substrate. The electric device is disposed on the substrate and is electrically connected to the photovoltaic cell. The cover covers the substrate, the photovoltaic cell, and the electric device. The cover has a first depression formed therein. The first depression receives at least a portion of the electric device. The encapsulating material is located between the substrate and the cover. The encapsulating material at least partially encapsulates the photovoltaic cell and the electric device.

## Description

### RELATED APPLICATIONS

This application claims priority to Taiwan Application Serial Number 100137399, filed October 14, 2011, which is herein incorporated by reference.

### BACKGROUND

### Technical field

The present disclosure relates to a photovoltaic package device.

### Description of Related Art

Photovoltaic packages are devices to transform light into electricity by photovoltaic effect. In recent years, due to the considerable effort worldwide to promote renewable energy, the technology related to photovoltaic packages has developed significantly and at a rapid pace.

A photovoltaic package can be used not only for electricity generation outdoors, but also for electricity generation related to electric products used primarily indoors. Although the operating environment of a photovoltaic package application in an indoor electric product is not as extreme as that for an electric product used outdoors, the safety requirement is higher. The most frequently encountered problem with such a photovoltaic package is that related to the thermal effect caused by hot spots.

The leading causes of hot spots can be defects of a photovoltaic cell itself, uneven soldering, partial shading, and individual differences of every photovoltaic cell. Among these causes, partial shading is the most difficult to control and prevent. If a photovoltaic cell is partially shaded during usage, the shaded part will cause extremely high resistance and raise the temperature of some areas rapidly.

Traditionally, manufacturers have used a diode placed in parallel to solve the partial shading problem. However, since current diodes have a far greater height than a photovoltaic cell, the encapsulating process is extremely difficult and breakage occurs more frequently.

### SUMMARY

A photovoltaic package device is provided as an embodiment of the invention. The photovoltaic package device is used to solve the difficulties encountered in the related art.

According to one embodiment of the present invention, a photovoltaic package device includes a substrate, a photovoltaic cell, an electric device, a cover and an encapsulating material. The photovoltaic cell is disposed on the substrate. The electric device is disposed on the substrate and is electrically connected to the photovoltaic cell. The cover covers the substrate, the photovoltaic cell, and the electric device. The cover includes a first depression for receiving at least a portion of the electric device. The encapsulating material is located between the substrate and the cover and at least partially encapsulates the photovoltaic cell and the electric device.

In one or a plurality of embodiments of the present invention, the electric device includes a diode.

In one or a plurality of embodiments of the present invention, the cover includes a photovoltaic cell cover and an electric device cover. The photovoltaic cell cover covers the photovoltaic cell. The electric device cover extends from a side edge of the photovoltaic cell and covers the electric device. The photovoltaic cell cover is thicker than the electric device cover, and the first depression is formed by a side surface of the photovoltaic cell cover next to the electric device cover and an inner surface of the electric device cover facing the electric device.

In one or a plurality of embodiments of the present invention, the photovoltaic package further includes a frame in which the assembly of the substrate, the photovoltaic cell, the electric device, the cover, and the encapsulating material is disposed is disposed. The edge of the frame covers the border between the photovoltaic cell cover and the electric device cover.

In one or a plurality of embodiments of the present invention, the cover includes an outer cover covering the substrate, the photovoltaic cell and the electric device, and an inner cover. The inner cover is disposed between the outer cover and the photovoltaic cell. A surface area of the outer cover is larger than a surface area of the inner cover, and the first depression is formed by the space between the inner cover edge and the outer cover edge.

In one or a plurality of embodiments of the present invention, the substrate includes a second depression. The electric device is at least partially disposed in the second depression.

In one or a plurality of embodiments of the present invention, the substrate includes a photovoltaic cell base and an electric device base. The photovoltaic cell is disposed on and above the photovoltaic cell base. The electric device is disposed on and extends from a side edge of the photovoltaic cell base. The photovoltaic cell base is thicker than the electric device base therein, and the second depression is formed by a side surface of the photovoltaic cell base next to the electric device base and an inner surface of the electric device base facing the electric device.

In one or a plurality of embodiments of the present invention, the substrate includes an inner plate and an outer plate. The photovoltaic cell is disposed on the inner plate. The outer plate is disposed on an outer surface of the inner plate facing away from the photovoltaic cell. A surface area of the outer plate is larger than the outer surface area of the inner plate therein, and the second depression is formed by a space between the edge of the inner plate and the edge of the outer plate.

According to another embodiment of the present invention, a photovoltaic package includes a substrate, a photovoltaic cell, an electric device, a cover and an encapsulating material. The substrate comprises a depression. The photovoltaic cell is disposed on the substrate. The electric device is at least partially disposed on the substrate and is electrically connected to the photovoltaic cell. The cover covers the substrate, the photovoltaic cell, and the electric device. The encapsulating material is disposed between the substrate and the cover and at least partially encapsulates the photovoltaic cell and the electric device.

In one or a plurality of embodiments of the present invention, the electric device includes a diode.

In one or a plurality of embodiments of the present invention, the substrate includes a photovoltaic cell base and an electric device base. The photovoltaic cell is disposed on the photovoltaic cell base. The electric device is disposed on and extends from a side edge of the photovoltaic cell base. The photovoltaic cell base is thicker than the electric device base therein, and the depression is formed by a side surface of the photovoltaic cell base next to the electric device base and an inner surface of the electric device base facing the electric device.

In one or a plurality of embodiments of the present invention, the photovoltaic package further includes a frame in which is disposed the assembly of the substrate, the photovoltaic cell, the electric device, the cover, and the encapsulating material. The edge of the frame covers the border between the photovoltaic cell base and the electric device base.

In one or a plurality of embodiments of the present invention, the substrate includes an inner plate and an outer plate. The photovoltaic cell is disposed on the inner plate. The outer plate is disposed on an outer surface of the inner plate facing away from the photovoltaic cell. A surface area of the outer plate is larger than the outer surface area of the inner plate therein, and the depression is formed by a space between the edge of the inner plate and the edge of the outer plate.

It is to be understood that both the foregoing general description and the following detailed description are by examples, and are intended to provide further explanation of the invention as claimed.

### BRIEF DESCRIPTION OF THE DRAWINGS

The invention can be more fully understood by reading the following detailed description of the embodiment, with reference made to the accompanying drawings as follows:
Fig. 1 is a top view of a photovoltaic package device according to the first embodiment of the invention;
Fig. 2 is a cross-sectional view of the photovoltaic package device along the section line 2-2 of Fig. 1;
Fig. 3 is a cross-sectional view of the photovoltaic package device according to the second embodiment of the invention;
Fig. 4 is a cross-sectional view of the photovoltaic package device according to the third embodiment of the invention;
Fig. 5 is a cross-sectional view of the photovoltaic package device according to the fourth embodiment of the invention;
Fig. 6 is a cross-sectional view of the photovoltaic package device according to the fifth embodiment of the invention;
Fig. 7 is a cross-sectional view of the photovoltaic package device according to the sixth embodiment of the invention;
Fig. 8 is a cross-sectional view of the photovoltaic package device according to the seventh embodiment of the invention;
Fig. 9 is a cross-sectional view of the photovoltaic package device according to the eighth embodiment of the invention;
Fig. 10 is a cross-sectional view of the photovoltaic package device according to the ninth embodiment of the invention;
Fig. 11 is a cross-sectional view of the photovoltaic package device according to the tenth embodiment of the invention;
Fig. 12 is a cross-sectional view of the photovoltaic package device according to the eleventh embodiment of the invention; and
Fig. 13 is a cross-sectional view of the photovoltaic package device according to the twelfth embodiment of the invention.

### DETAILED DESCRIPTION

Reference will now be made in detail to the present embodiments of the invention, examples of which are illustrated in the accompanying drawings. Wherever possible, the same reference numbers are used in the drawings and the description to refer to the same or like parts.

### The first embodiment

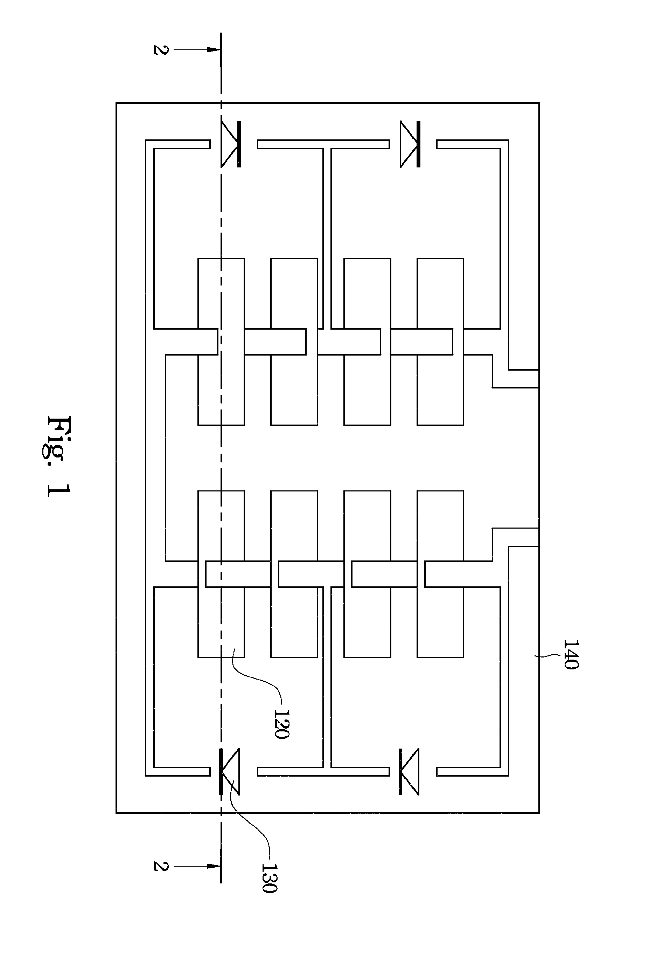

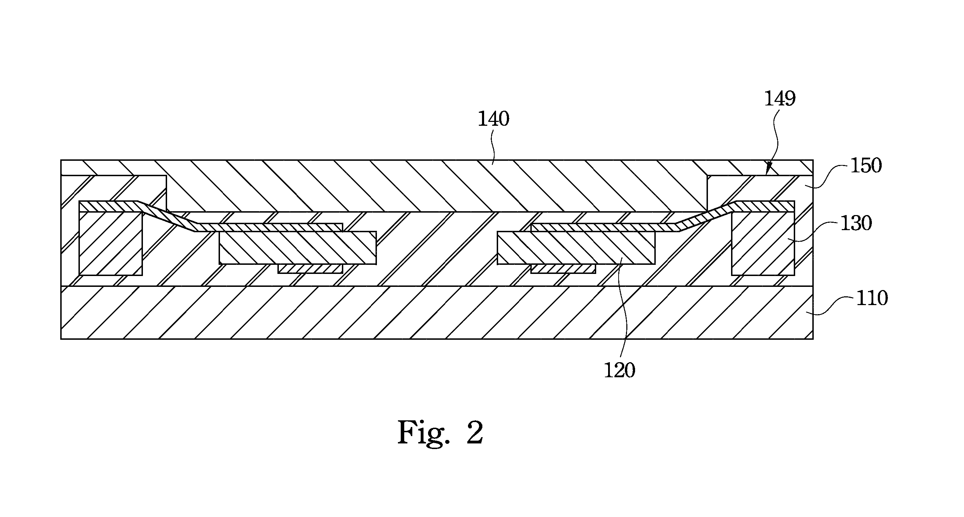

Fig. 1 is a top view of a photovoltaic package device according to the first embodiment of the invention. Fig. 2 is a cross-sectional view of the photovoltaic package along the section line 2-2 of Fig. 1. In the figures, a photovoltaic package device includes a substrate 110, a plurality of photovoltaic cells 120, a plurality of electric devices 130, a cover 140 and an encapsulating material 150. The photovoltaic cells 120 are disposed on the substrate 110. The electric devices 130 are disposed on the substrate 110 and are electrically connected to the photovoltaic cells 120. The cover 140 covers the substrate 110, the photovoltaic cells 120, and the electric devices 130. The cover 140 includes a first depression 149 in which is received at least a portion of the electric devices 130. For example, the electric devices 130 are disposed on the substrate 110 and around the photovoltaic cells 120 or at two opposite sides of the photovoltaic cells 120. Consequently, the first depression 149 corresponding to the electric devices 130 can be disposed around or at two opposite sides of the cover 140. The encapsulating material 150 is located between the substrate 110 and the cover 140 and at least partially encapsulates the photovoltaic cells 120 and the electric devices 130.

The term "on" herein represents "on or above". For example, if the photovoltaic cells 120 are described as being disposed on the substrate 110, this indicates that the photovoltaic cells 120 are disposed on or above the substrate 110. That is, the photovoltaic cells 120 can contact the substrate 110 or can be spaced apart from the substrate 110.

In Fig. 2, because the first depression 149 can receive at least a portion of the electrical devices 130, the height difference between such a portion of the electrical devices 130 and the photovoltaic cells 120 can be compensated for. This design can make an encapsulating process easier and also reduces the chance of breakage during manufacture. Furthermore, because the first depression 149 can receive at least a portion of the electrical devices 130, the total thickness of the photovoltaic package will not increase even though the electrical devices 130 have a greater height than the photovoltaic cells 120.

In this embodiment, the material of the above substrate 110 can be glass, plastic or any combination thereof. For example, tempered glass, polyvinyl fluoride(PVF, e.g. tedlar® produced by Dupont), polyethylene terephthalate(PET), polyethylene naphthalate(PEN), or any combination thereof can be used for the material of the substrate 110. It should be understood that such different materials that can be used for the substrate 110 are mentioned by way of example, and do not limit the invention. Persons skilled in the art may select such aspects of the substrate 110 in a flexible manner and depending on actual requirements.

In this embodiment, each of the photovoltaic cells 120 can be a monocrystalline silicon photovoltaic cell, a polycrystalline silicon photovoltaic cell, an amorphous silicon photovoltaic cell, a cadmium telluride photovoltaic cell, a copper Indium selenide photovoltaic cell, a gallium arsenide photovoltaic cell, a photochemical cell, a die-sensitized photovoltaic cell, a polymer photovoltaic cell, a nanocrystalline photovoltaic cell, or any combination thereof. Likewise, the different types of photovoltaic cells that can be used for the photovoltaic cells 120 are mentioned by way of example, and do not limit the invention. Persons skilled in the art may select such aspects of the photovoltaic cells 120 in a flexible manner and depending on actual requirements.

In this embodiment, each of the electrical devices 130 can be a control circuit unit, a bypass circuit unit, a diode, a maximum power point tracking charge controller or any combination thereof. In one or a plurality of the embodiments, the electric devices 130 have a greater height than the photovoltaic cells 120. For example, in an embodiment where each of the electric devices 130 is a diode, the height of the electric device 130 can be approximately 0.7 mm, while the height of each of the photovoltaic cells 120 can be approximately 0.2 mm.

As in the case of the substrate 110, the material of the cover 140 can be glass, plastic or any combination thereof. For example, tempered glass, polyvinyl fluoride(PVF, e.g. tedlar® produced by Dupont), polyethylene terephthalate(PET), polyethylene naphthalate(PEN), or any combination thereof can be used for the material of the cover 140. It should be understood that such materials that can be used for the cover 140 are mentioned by way of example, and do not limit the invention. Persons skilled in the art may select such aspects of the cover 140 in a flexible manner and depending on actual requirements.

In this embodiment, the cover 140 can be a unibody glass or plastic. During manufacture, manufactures can choose to form the cover 140 and the first depression 149 together in a molding process or to manufacture the cover 140 in a molding process first and then the first depression 149 using a cutting process.

In this embodiment, the encapsulating material 150 can be any water-resistant material that is able to prevent oxygen penetration, and that also prevents breakage of the photovoltaic cells 120 and combines the cover 140 and the substrate 110. For example, ethylene vinyl acetate(EVA), epoxy or any combination thereof may be used as the material for the encapsulating material 150. It should be understood that the materials used for the encapsulating material 150 are mentioned by way of example, and do not limit the invention. Persons skilled in the art may select such aspects of the encapsulating material 150 in a flexible manner and depending on actual requirements.

### The second embodiment

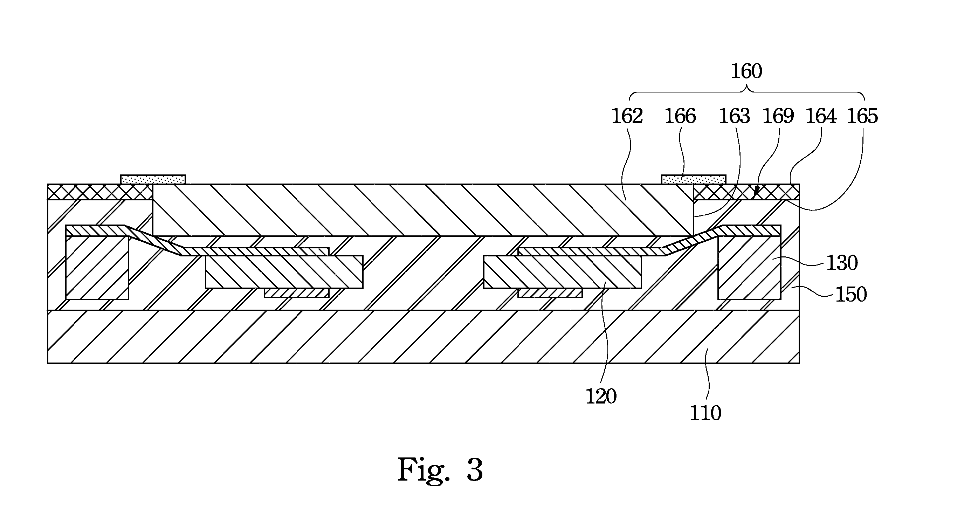

Fig. 3 is a cross-sectional view of the photovoltaic package device according to the second embodiment of the invention. The location where the cross section is taken is the same as Fig. 2. The difference between this embodiment and the first embodiment in Fig. 1 and Fig.2 is that a cover 160 of this embodiment includes a photovoltaic cell cover 162 and an electric device cover 164. The photovoltaic cell cover 162 covers the photovoltaic cells 120. The electric device cover 164 extends from the side edge of the photovoltaic cell cover 162 and covers the electric devices 130. For example, the electric device cover 164 is disposed around or at two opposite sides of the photovoltaic cell cover 162. The photovoltaic cell cover 162 is thicker than the electric device cover 164, and as a result, the edge of the photovoltaic cell cover 162 and the electric device cover 164 are on different levels (i.e., they have different heights). Through such a configuration, a side surface 163 of the photovoltaic cell cover 162 next to the electric device cover 164 and an inner surface 165 of the electric device cover 164 facing the electric device 130 form a first depression 169.

In this embodiment, the material of the photovoltaic cell cover 162 and the electric device cover 164 can be glass, plastic or any combination thereof. For example, tempered glass, polyvinyl fluoride(PVF, e.g. tedlar® produced by Dupont), polyethylene terephthalate(PET), polyethylene naphthalate(PEN), or any combination thereof can be used for the material of the photovoltaic cell cover 162 and the electric device cover. It should be understood that such materials that can be used for the photovoltaic cell cover 162 and the electric device cover 164 are mentioned by way of example, and do not limit the invention. Persons skilled in the art may select such aspects of the electric device cover 164 in a flexible manner and depending on actual requirements.

Furthermore, the material of the photovoltaic cell cover 162 and that for the electric device cover 164 can be the same or different. For example, in some embodiments, the material of the photovoltaic cell cover 162 can be tempered glass and the material of the electric device cover 164 can be polyethylene terephthalate(PET).

In one or a plurality of embodiments of the present invention, considering that manufacturing the cover 160 as a unibody is difficult, manufacturers can produce the photovoltaic cell cover 162 and the electric device cover 164 separately, then utilize an adhesive 166 to bond the photovoltaic cell cover 162 and the electric device cover 164. The particular type of the adhesive 166 used depends on the material of the photovoltaic cell cover 162 and that of the electric device cover 164, and it is necessary only that the adhesive 166 is able to bond the photovoltaic cell cover 162 and the electric device cover 164. For example, the adhesive 166 can be, but is not limited to being, a double-sided tape, a tape (having an adhesive property on only one side thereof), a paper tape, silicone, epoxy resin, polyurethane adhesive, a polymethyl methacrylate (PMMA) adhesive, an encapsulating adhesive, a hot-melt adhesive, a UV adhesive, or any combination thereof.

As to other relevant structures, materials, and process details, these aspects of the second embodiment are all the same as the first embodiment in Fig. 1 and Fig. 2, and therefore, a description of these aspects will not be repeated.

### The third embodiment

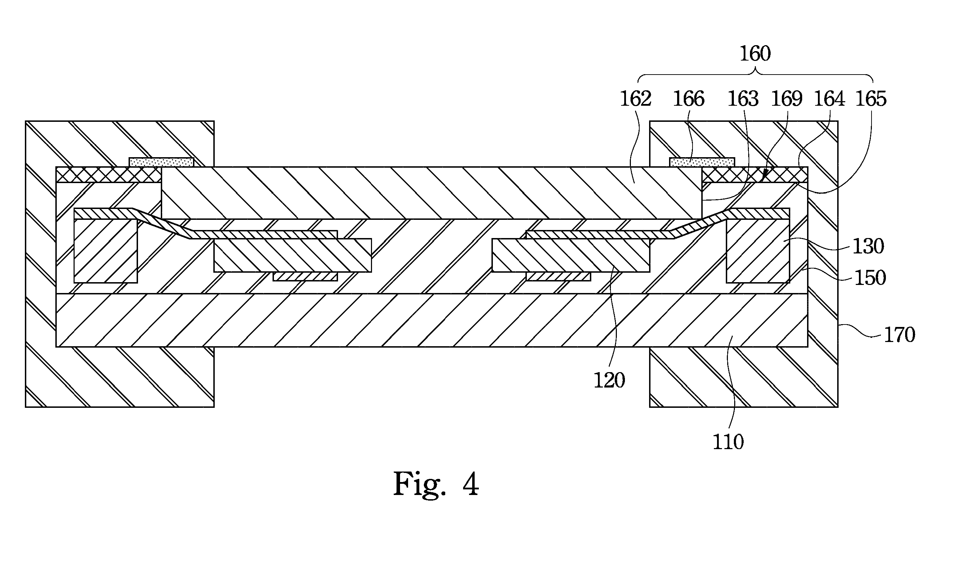

Fig. 4 is a cross-sectional view of the photovoltaic package device according to the third embodiment of the invention. The location where the cross section is taken is the same as Fig. 2. The difference between this embodiment and the second embodiment in Fig. 3 is that the photovoltaic package of this embodiment further includes a frame 170 an assembly of the substrate 110, the photovoltaic cells 120, the electric devices 130, the cover 160, and the encapsulating material 150 is disposed in the frame 170. Edges of the frame 170 cover the border between the photovoltaic cell cover 162 and the electric device cover 164.

In this embodiment, because there are discontinuous gaps and/or the presence of the adhesive 166 at the border between the photovoltaic cell cover 162 and the electric device cover 164, manufacturers can make use of the edges of the frame 170 to cover these gaps and/or the adhesive 166 to improve the appearance of the end product. Furthermore, when the photovoltaic package is applied in an electric device, the frame 170 can be a part of the housing of the electric device. The material of the frame 17 can be, but is not limited to being, plastic, metal, wood, carbon fiber, leather, or any combination thereof.

As to other relevant structures, materials, and process details, these aspects of the third embodiment are all the same as the second embodiment in Fig. 3, and therefore, a description of these aspects will not be repeated.

### The fourth embodiment

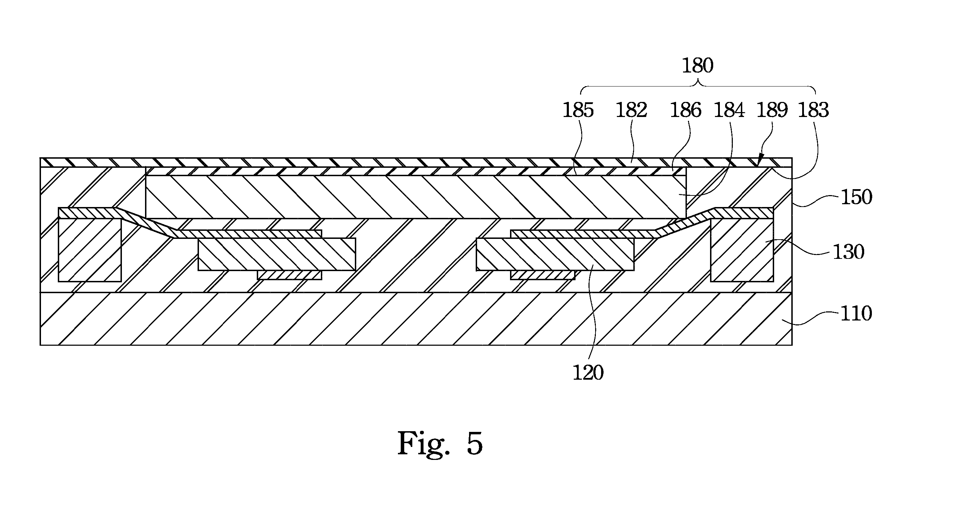

Fig. 5 is a cross-sectional view of the photovoltaic package device according to the fourth embodiment of the invention. The location where the cross section is taken is the same as Fig. 2. The difference between this embodiment and the first embodiment in Fig. 1 and Fig. 2 is that a cover 180 of this embodiment includes an outer cover 182 and an inner cover 184. The outer cover 182 covers the substrate 110, the photovoltaic cells 120, and the electrical devices 130.The inner cover 184 is disposed between the outer cover 182 and the photovoltaic cells 120. A surface 183 area of the outer cover 182 is larger than a surface area 185 of the inner cover 184, and as a result, a bottom surface of the inner cover 184 and a bottom surface of the outer cover 182 are on different levels (i.e., they have different heights). Hence, a first depression 189 to receive a portion of the electrical devices 130 is formed by the outer and inner covers 182, 184.

In the embodiment, the material of the outer cover 182 and the inner cover 184 can be glass, plastic or any combination thereof. For example, tempered glass, polyvinyl fluoride(PVF, e.g. tedlar® produced by Dupont), polyethylene terephthalate(PET), polyethylene naphthalate(PEN), or any combination thereof can be used for the material of the outer and inner covers 182, 184. It should be understood that such materials that can be used for the outer cover 182 and the inner cover 184 are mentioned by way of example, and do not limit the invention. Persons skilled in the art may select such aspects of the outer cover 182 and the inner cover 184 in a flexible manner and depending on actual requirements.

Furthermore, the material of the outer cover 182 and that for the inner cover 184 can be the same or different. For example, in some embodiments, the material for each of the outer cover 182 and the inner cover 184 can be tempered glass. In other embodiments, the inner cover 184 can be tempered glass, while the outer cover 182 can be polyethylene terephthalate(PET).

In one or a plurality of embodiments of the present invention, considering that manufacturing the cover 180 as a unibody is difficult, manufacturers can produce the outer cover 182 and the inner cover 184 separately, then use an adhesive 186 to bond the outer cover 182 and the inner cover 184. The particular type of the adhesive 186 used depends on the material of the outer cover 182 and that of the inner cover 184, and it is necessary only that the adhesive 186 is able to bond the outer cover 182 and the inner cover 184. For example, the adhesive 186 can be, but is not limited to being, a double-sided tape, a tape (having an adhesive property on only one side thereof), a paper tape, silicone, epoxy resin, polyurethane adhesive, a polymethyl methacrylate (PMMA) adhesive, an encapsulating adhesive, a hot-melt adhesive, a UV adhesive, or any combination thereof.

As to other relevant structures, materials, and process details, these aspects of the fourth embodiment are all the same as the first embodiment in Fig. 1 and Fig. 2, and therefore, a description of these aspects will not be repeated.

### The fifth embodiment

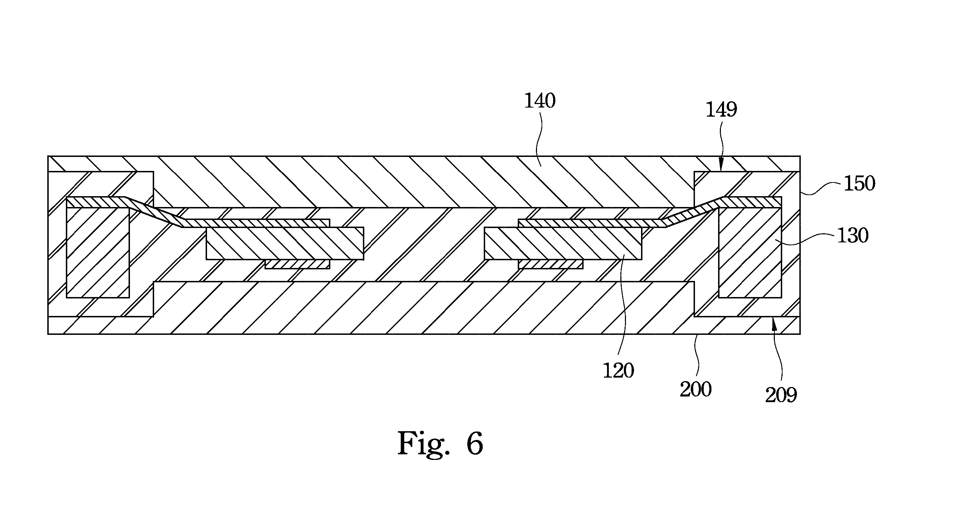

Fig. 6 is a cross-sectional view of the photovoltaic package device according to the fifth embodiment of the invention. The location where the cross section is taken is the same as Fig. 2. The difference between this embodiment and the first embodiment in Fig. 1 and Fig. 2 is that a substrate 200 of this embodiment includes a second depression 209. The electrical devices 130 are at least partially disposed in the second depression 209. For example, the electric devices 130 are disposed around or at two opposite sides of a plurality of the photovoltaic cells 120 on the substrate 110. Therefore, the second depression 209, which corresponds to the electric devices 130, can be disposed around or at two opposite sides of the substrate 110.

Under some circumstances, the first depression 149 may not be able to compensate for the height difference between the electric devices 130 and the photovoltaic cells 120. To remedy this situation, manufacturers can choose to further form the second depression 209 on the substrate 200 and therefore make for the inability of the first depression 149 to fully compensate for this height differential between the electric devices 130 and the photovoltaic cells 120.

In this embodiment, the substrate 200 can be a unibody made of glass or plastic. During manufacture, manufactures can choose to form the substrate 200 and the second depression 209 together in a molding process or manufacture the substrate 200 in a molding process first and then the second depression 209 using a cutting process.

As to other relevant structures, materials, and process details, these aspects of the fifth embodiment are all the same as the first embodiment in Fig. 1 and Fig. 2, and therefore, a description of these aspects will not be repeated.

### The sixth embodiment

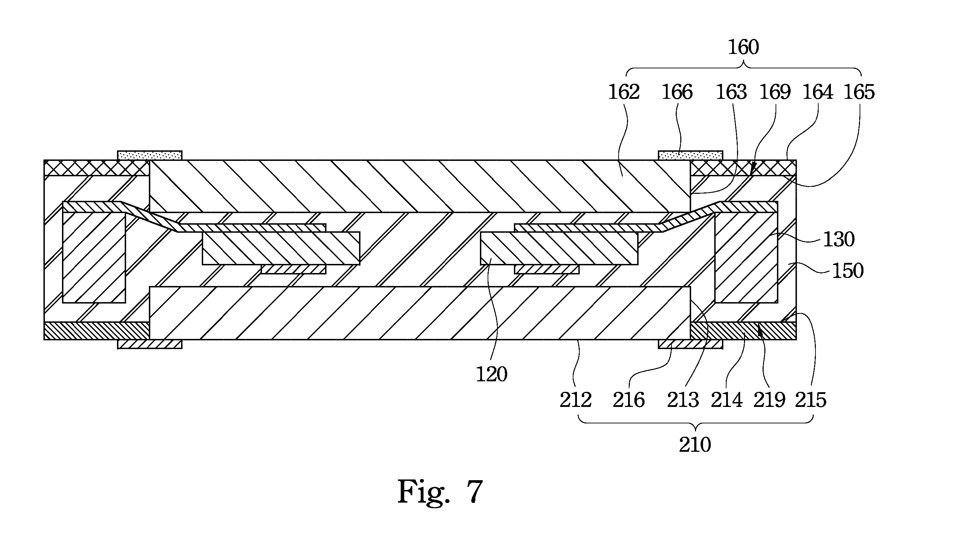

Fig. 7 is a cross-sectional view of the photovoltaic package device according to the sixth embodiment of the invention. The location where the cross section is taken is the same as Fig. 2. The difference between this embodiment and the second embodiment is that a substrate 210 of this embodiment includes a photovoltaic cell base 212 and an electric device base 214. The photovoltaic cells 120 are disposed on and above the photovoltaic cell base 212. The electric device base 214 extends from the side edge of the photovoltaic cell base 212. For example, the electric device base 214 can be disposed around or at opposite sides of the photovoltaic cell base 212. The photovoltaic cell base 212 is thicker than the electric device base 214, and as a result, the photovoltaic cell base 212 and the electric device base 214 are on different levels (i.e., they have different heights) and form a second depression 219. Through such a configuration, a side surface 213 of the photovoltaic cell base 212 next to the electric device base 214 and an inner surface 215 of the electric device base 214 facing the electric devices 130 form a second depression 219.

In this embodiment, the material of the photovoltaic cell base 212 and the electric device base 214 can be glass, plastic or any combination thereof. For example, tempered glass, polyvinyl fluoride(PVF, e.g. tedlar® produced by Dupont), polyethylene terephthalate(PET), polyethylene naphthalate(PEN), or any combination thereof can be used for the material of the photovoltaic cell base 212 and the electric device base 214. It should be understood that such materials that can be used for the photovoltaic cell base 212 and the electric device base 214 are mentioned by way of example, and do not limit the invention. Persons skilled in the art may select such aspects of the photovoltaic cell base 212 and the electric device base 214 in a flexible manner and depending on actual requirements.

Furthermore, the material of the photovoltaic cell base 212 and the electric device base 214 can be the same or different. For example, in some embodiments, the material of the photovoltaic cell base 212 and the electric device base 214 can be tempered glass. In other embodiments, the photovoltaic cell base 212 can be tempered glass, while the electric device base 214 can be polyethylene terephthalate(PET).

In one or a plurality of embodiments of the present invention, considering that manufacturing the cover 180 as a unibody is difficult, manufacturers can produce the photovoltaic cell base 212 and the electric device base 214 separately, then use an adhesive 216 to bond the photovoltaic cell base 212 and the electric device base 214. The particular type of the adhesive 216 used depends on the material of the photovoltaic cell base 212 and that of the electric device base 214, and it is necessary only that the adhesive 216 is able to bond the photovoltaic cell base 212 and the electric device base 214. For example, the adhesive 216 can be, but is not limited to being, a doubled-side tape, a tape (having an adhesive property on only one side thereof), a paper tape, silicone, epoxy resin, polyurethane adhesive, a polymethyl methacrylate (PMMA) adhesive, a encapsulating adhesive, a hot-melt adhesive, a UV adhesive, or any combination thereof.

As to other relevant structures, materials, and process details, these aspects of the sixth embodiment are all the same as the second embodiment in Fig. 3, and therefore, a description of these aspects will not be repeated.

### The seventh embodiment

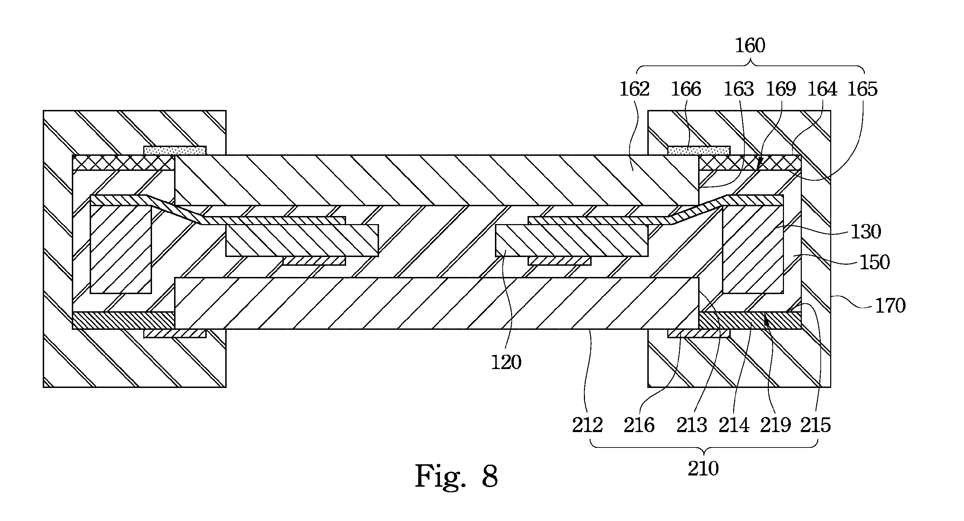

Fig. 8 is a cross-sectional view of the photovoltaic package device according to the seventh embodiment of the invention. The location where the cross section is taken is the same as Fig. 2. The difference between this embodiment and the sixth embodiment is that the photovoltaic package of the embodiment further includes the frame 170, and the assembly of the substrate 210, the photovoltaic cells 120, the electric devices 130, the cover 160, and the encapsulating material 150 is disposed in the frame 170. The edge of the frame 170 covers not only the border between the photovoltaic cell cover 162 and the electric device cover 164 but also the border between the photovoltaic cell base 212 and the electric device base 214.

In the embodiment, because there are discontinuous gaps and/or the presence of an adhesive 216 at the border between the photovoltaic cell base 212 and the electric device base 214, manufacturers can make use of the edge of the frame 170 to cover these gaps and/or the adhesive 216 to improve the appearance of the end product. Furthermore, when the photovoltaic package is applied in an electric device, the frame 170 can be a part of the housing of the electric device. The material of the frame 170 can be, but is not limited to being, plastic, metal, wood, carbon fiber, leather, or any combination thereof.

As to other relevant structures, materials, and process details, these aspects of the seventh embodiment are all the same as the sixth embodiment in Fig. 7, and therefore, a description of these aspects will not be repeated.

### The eighth embodiment

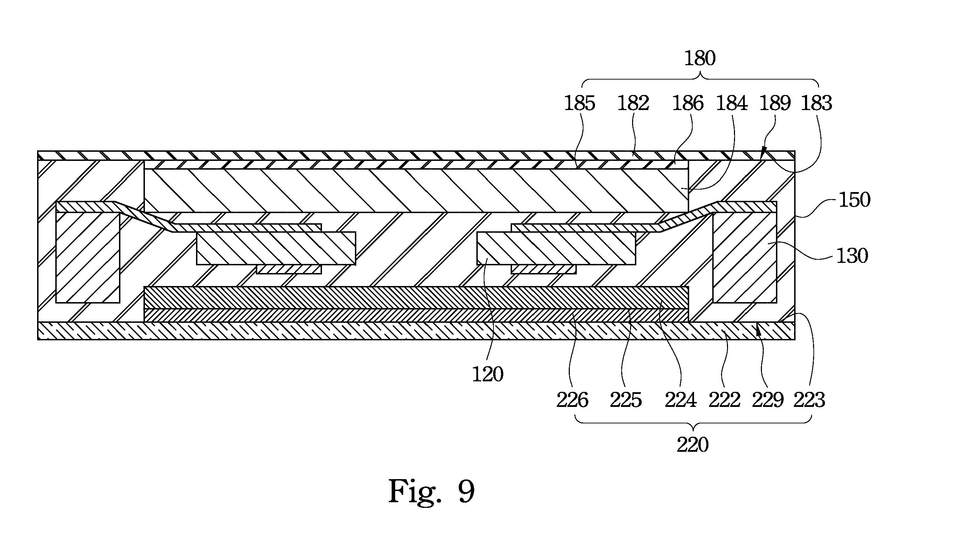

Fig. 9 is a cross-sectional view of the photovoltaic package device according to the eighth embodiment of the invention. The location where the cross section is taken is the same as Fig. 2. The difference between this embodiment and the fourth embodiment is that a substrate 220 of this embodiment includes an inner plate 224 and an outer plate 222. The photovoltaic cells 120 are disposed on the inner plate 224. The outer plate 222 is disposed on an outer surface 225 of the inner plate 224 with a (rear) surface 223 of the outer plate 222 facing the photovoltaic cells 120. The area of the surface 223 of the outer plate 222 is larger than the area of an outer surface 225 of the inner plate 224, such that the edge of the inner plate 224 and the edge of the outer plate 222 are on different levels (i.e., they have different heights) and form a second depression 229.

In this embodiment, the material of the inner plate 224 and the outer plate 222 can be glass, plastic or any combination thereof. For example, tempered glass, polyvinyl fluoride(PVF, e.g. tedlar® produced by Dupont), polyethylene terephthalate(PET), polyethylene naphthalate(PEN), or any combination thereof can be used for the material of the inner plate 224 and the outer plate 222. It should be understood that such materials that can be used for the inner plate 224 and the outer plate 222 are mentioned by way of example, and do not limit the invention. Persons skilled in the art may select such aspects of the inner plate 224 and the outer plate 222 in a flexible manner and depending on actual requirements.

Furthermore, the material of the inner plate 224 and that for the outer plate 222 can be the same or different. For example, in some embodiments, the material of the inner plate 224 and the outer plate 222 can be tempered glass. In other embodiments, the inner plate 224 and the outer plate 222 can be polyethylene terephthalate(PET).

In one or a plurality of embodiments of the present invention, considering that manufacturing the cover 180 as a unibody is difficult, manufacturers can produce the inner plate 224 and the outer plate 222 separately, then use an adhesive 226 to bond the inner plate 224 and the outer plate 222. The particular type of the adhesive 226 used depends on the material of the inner plate 224 and that of the outer plate 222, and it is necessary only that the adhesive 226 is able to bond the inner plate 224 and the outer plate 222. For example, the adhesive 226 can be, but is not limited to being, a double-sided tape, a tape (having an adhesive property on only one side thereof), a paper tape, silicone, epoxy resin, polyurethane adhesive, a polymethyl methacrylate (PMMA) adhesive, an encapsulating adhesive, a hot-melt adhesive, a UV adhesive, or any combination thereof.

As to other relevant structures, materials, and process details, these aspects of the eighth embodiment are all the same as the fourth embodiment in Fig. 5, and therefore, a description of these will not be repeated.

### The ninth embodiment

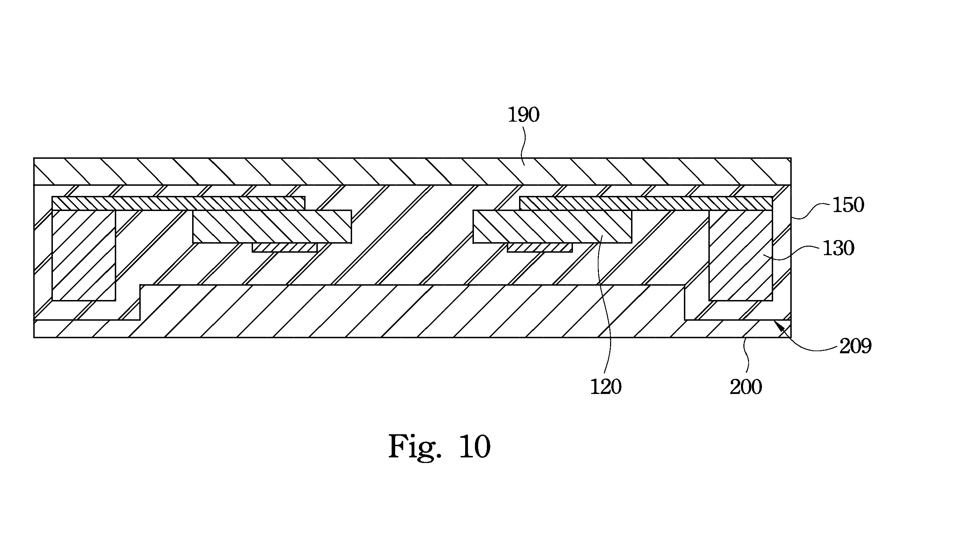

Fig. 10 is a cross-sectional view of the photovoltaic package device according to the ninth embodiment of the invention. The location where the cross section is taken is the same as Fig. 2. The difference between this embodiment and the fifth embodiment is that the second depression 209 is disposed only on the substrate 200, and the cover 190 is not formed with any depression.

That is to say, a configuration can be used in which the substrate 200 in Fig. 6 and Fig. 10 is combined with the cover 140 in Fig. 6 or the cover 190 designed without a depression in Fig. 10. Furthermore, a configuration can be used in which the substrate 200 in Fig. 6 and Fig. 10 is combined with the cover 160 in Fig. 7 or the cover 180 in Fig. 9. Persons skilled in the art may select such aspects of the substrate and the cover in a flexible manner and depending on actual requirements.

As to other relevant structures, materials, and process details, these aspects of the ninth embodiment are all the same as the fifth embodiment in Fig. 6, and therefore, a description of these aspects will not be repeated.

### The tenth embodiment

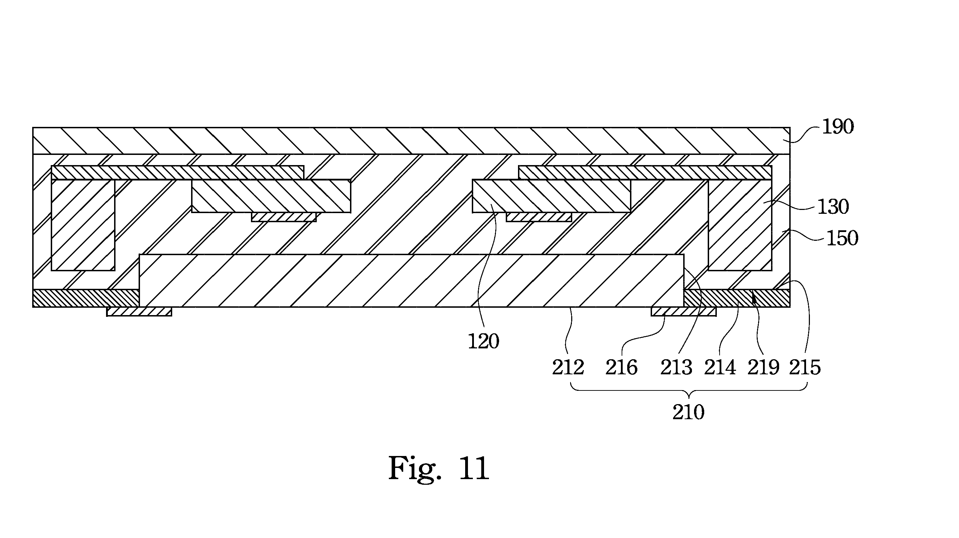

Fig. 11 is a cross-sectional view of the photovoltaic package device according to the tenth embodiment of the invention. The location where the cross section is taken is the same as Fig. 2. The difference between this embodiment and the fifth embodiment is that the second depression 219 is disposed only on the substrate 210, and the cover 190 is not formed with any depression.

That is to say, a configuration can be used in which the substrate 210 in Fig. 7 and Fig. 11 is combined with the cover 160 in Fig. 7 or the cover 190 designed without a depression in Fig. 11. Furthermore, a configuration can be used in which the substrate 210 in Fig. 7 and Fig. 11 is combined with the cover 140 in Fig. 6 or the cover 180 in Fig. 9. Persons skilled in the art may select such aspects of the substrate and the cover in a flexible manner and depending on actual requirements.

As to other relevant structures, materials, and process details, these aspects of the tenth embodiment are all the same as the sixth embodiment in Fig. 7, and therefore, a description of these aspects will not be repeated.

### The eleventh embodiment

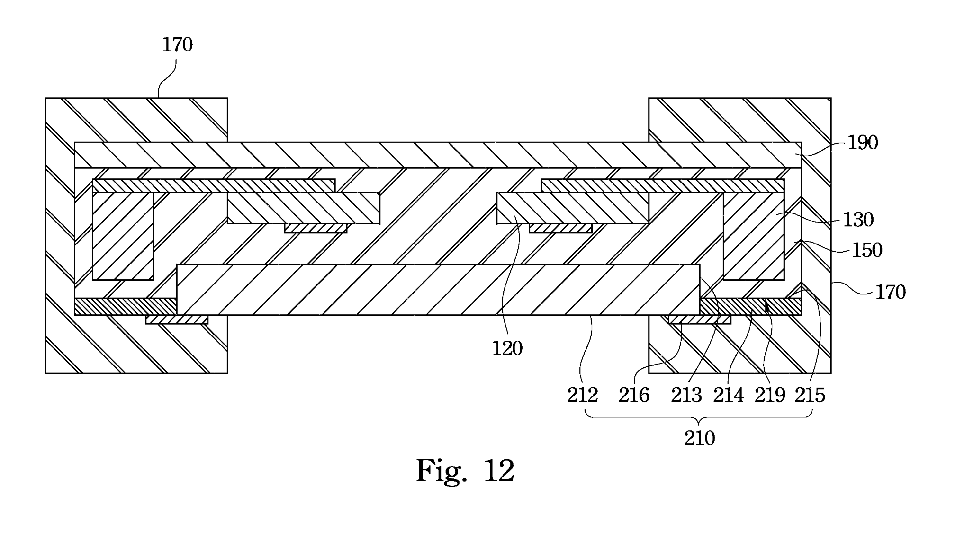

Fig. 12 is a cross-sectional view of the photovoltaic package device according to the eleventh embodiment of the invention. The location where the cross section is taken is the same as Fig. 2.

The difference between this embodiment and the seventh embodiment is that the second depression 219 is disposed only on the substrate 210, and the cover 190 is not formed with a depression.

As to other relevant structures, materials, and process details, these aspects of the eleventh embodiment are all the same as the seventh embodiment in Fig. 8, and therefore, a description of these aspects will not be repeated.

### The twelfth embodiment

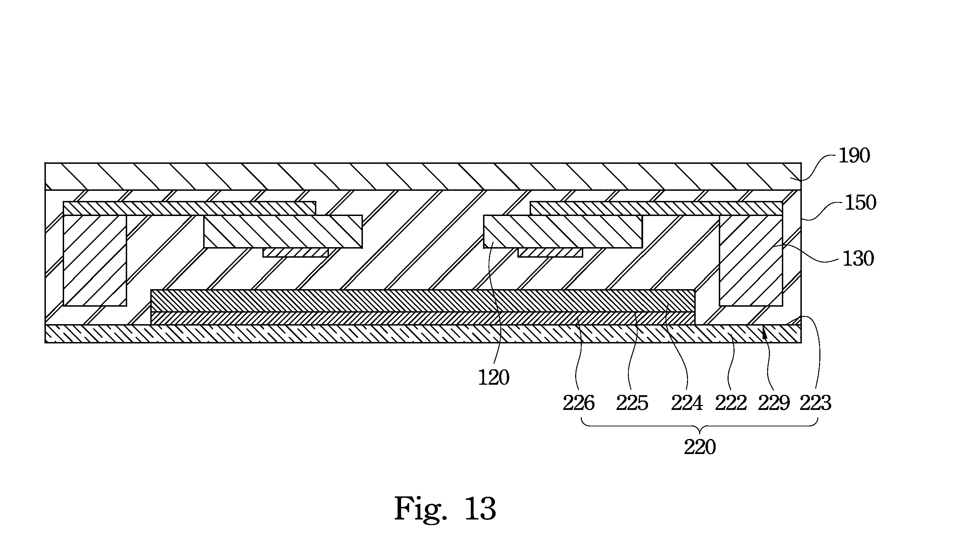

Fig. 13 is a cross-sectional view of the photovoltaic package device according to the twelfth embodiment of the invention. The location where the cross section is taken is the same as Fig. 2.The difference between this embodiment and the eighth embodiment is that the second depression 229 is disposed only on the substrate 220, and the cover 190 is not formed with a first depression.

That is to say, a configuration can be used in which the substrate 220 in Fig. 9 and Fig. 13 is combined with the cover 180 in Fig. 9 or the cover 190 designed without a depression in Fig. 13. Furthermore, a configuration can be used in which the substrate 220 in Fig. 9 and Fig. 13 is combined with the cover 140 in Fig. 6 or the cover 160 in Fig. 7. Persons skilled in the art may select such aspects of the substrate and the cover in a flexible manner and depending on actual requirements.

As to other relevant structures, materials, and process details, these aspects of the twelfth embodiment are all the same as the eighth embodiment in Fig. 9, and therefore, a description of these aspects will not be repeated.

Although the present invention has been described in considerable detail with reference to certain embodiments thereof, other embodiments are possible. Therefore, the spirit and scope of the appended claims should not be limited to the description of the embodiments contained herein. It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims.

## Claims

1. A photovoltaic package, **characterized by** comprising:
a substrate (110, 210, 220);
a photovoltaic cell (120) disposed on the substrate (110, 210, 220);
an electric device (130) disposed on the substrate (110, 210, 220) and electrically connected to the photovoltaic cell (120);
a cover (140, 160, 180,190) covering the substrate (110, 210, 220), the photovoltaic cell (120), and the electric device (130), wherein the cover (140) comprises a first depression (149) for receiving at least a portion of the electric device (130); and
an encapsulating material (150) located between the substrate (110, 210, 220) and the cover (140, 160, 180,190) and at least partially encapsulating the photovoltaic cell (120) and the electric device (130).

2. The photovoltaic package of claim 1, **characterized in that** the electric device (130) comprises a diode.

3. The photovoltaic package of claim 1, **characterized in that** the cover (160) comprises:
a photovoltaic cell cover (162) covering the photovoltaic cell (120); and
an electric device cover (164) extending from a side edge of the photovoltaic cell cover (162) and covering the electric device (130), wherein the photovoltaic cell cover (162) is thicker than the electric device cover (164), and the first depression is formed by a side surface (163) of the photovoltaic cell cover (162) next to the electric device cover (164) and an inner surface (165) of the electric device cover (164) facing the electric device (130).

4. The photovoltaic package of claim 3, **characterized by** further comprising:
a frame (170), wherein the assembly of the substrate (210), the photovoltaic cell (120), the electric device (130), the cover (160), and the encapsulating material (150) is disposed in the frame(170), and the edge of the frame (170) covers the border between the photovoltaic cell cover (162) and the electric device cover (164).

5. The photovoltaic package of claim 1, **characterized in that** the cover (180) comprises:
an outer cover (182) covering the substrate (110), the photovoltaic cell (120) and the electric device (130); and
an inner cover (184) disposed between the outer cover (182) and the photovoltaic cell (120), wherein a surface area of the outer cover (182) is larger than a surface area of the inner cover (184), and the first depression is formed by a space between the inner cover edge and the outer cover edge.

6. The photovoltaic package of claim 1, **characterized in that** the substrate (210) comprises a second depression (209), and the electric device (130) is at least partially disposed in the second depression (209).

7. The photovoltaic package of claim 6, **characterized in that** the substrate (210) comprises:
a photovoltaic cell base (212), the photovoltaic cell (120) being disposed on the photovoltaic base (212); and
an electric device base (214), the electric device (130) being disposed on and extending from a side edge of the photovoltaic cell base (212), wherein the photovoltaic cell base (212) is thicker than the electric device base (214), and the second depression is formed by a side surface (213) of the photovoltaic cell base (212) next to the electric device base (214) and an inner surface (215) of the electric device base (214) facing the electric device (130).

8. The photovoltaic package of claim 6, **characterized in that** the substrate (220) comprises:
an inner plate (224), the photovoltaic cell (120) being disposed on the inner plate (224); and
an outer plate (222) disposed on an outer surface (225) of the inner plate (224) facing away from the photovoltaic cell (120), wherein a surface area of the outer plate (222) is larger than the outer surface area of the inner plate (224), and the second depression is formed by a space between the edge of the inner plate (224) and the edge of the outer plate (222).

9. A photovoltaic package, **characterized by** comprising:
a substrate (110, 210, 220) comprising a depression (209);
a photovoltaic cell (120) disposed on the substrate (110, 210, 220);
an electric device (130) at least partially disposed on the substrate (110, 210, 220) and electrically connected to the photovoltaic cell (120);
a cover (140, 160, 180,190) covering the substrate (110, 210, 220), the photovoltaic cell (120), and the electric device (130); and
an encapsulating material (150) disposed between the substrate (110, 210, 220) and the cover (140, 160, 180,190) and at least partially encapsulating the photovoltaic cell (120) and the electric device (130).

10. The photovoltaic package of claim 9, **characterized in that** the electric device (130) comprises a diode.

11. The photovoltaic package of claim 9, **characterized in that** the substrate (160) comprises:
a photovoltaic cell base (162), the photovoltaic cell (120) being disposed on the photovoltaic cell base (162); and
an electric device base (164), the electric device (130) being disposed on and extending from a side edge of the photovoltaic cell base (162), wherein the photovoltaic cell base (162) is thicker than the electric device base (164), and the depression is formed by a side surface (163) of the photovoltaic cell base (162) next to the electric device base (164) and an inner surface (165) of the electric device base (164) facing the electric device (130).

12. The photovoltaic package of claim 9, **characterized by** further comprising:
a frame (170), wherein the assembly of the substrate (210), the photovoltaic cell (120), the electric device (130), the cover (160), and the encapsulating material (150) is disposed in the frame (170), and the edge of the frame (170) covers the border between the photovoltaic cell base (162) and the electric device base (164).

13. The photovoltaic package of claim 9, **characterized in that** the substrate (220) comprises:
an inner plate (224), the photovoltaic cell (120) being disposed on the inner plate (224); and
an outer plate (222) disposed on an outer surface (225) of the inner plate (224) facing away from the photovoltaic cell (120), wherein a surface area of the outer plate (222) is larger than the outer surface area (225) of the inner plate (224), and the depression is formed by a space between the edge of the inner plate (224) and the edge of the outer plate (222).
